# EUROPÄISCHE PATENTSCHRIFT

(11) **EP 3 109 651 B1**
(45) Veröffentlichungstag und Bekanntmachung des Hinweises auf die Patenterteilung: **12.08.2020**
(21) Anmeldenummer: 16176247.1
(22) Anmeldetag: 24.06.2016
(51) Int. Cl.: G01R 31/34, G01R 19/25, H02P 21/14, H02K 11/20

(54) **VERFAHREN ZUM ERMITTELN MINDESTENS EINER KENNGRÖSSE EINER ELEKTRISCHEN MASCHINE UND FREQUENZUMRICHTER**
METHOD FOR DETERMINING AT LEAST ONE PARAMETER OF AN ELECTRIC MACHINE AND FREQUENCY CONVERTER
PROCÉDÉ POUR LA DÉTERMINATION D'AU MOINS UNE GRANDEUR CARACTÉRISTIQUE D'UNE MACHINE ÉLECTRIQUE ET CONVERTISSEUR DE FRÉQUENCE

(30) Priorität: 25.06.2015 DE 102015211860
(43) Veröffentlichungstag der Anmeldung: 28.12.2016
(73) Patentinhaber: Lenze Automation GmbH, 31855 Aerzen (DE)
(72) Erfinder: Düsterberg, Dirk, 31860 Emmerthal (DE)
(74) Vertreter: Patentanwälte Ruff, Wilhelm, Beier, Dauster & Partner mbB

(56) Entgegenhaltungen:
- DE-A1-102010 042 946
- DE-A1-102011 080 586
- DE-A1-102013 201 253
- DE-A1-102014 116 216
- GB-A- 2 440 559
- US-A- 5 477 163

## Beschreibung

Die Erfindung betrifft ein Verfahren zum Ermitteln mindestens einer Kenngröße einer elektrischen Maschine und einen Frequenzumrichter.

Zum Ermitteln von Kenngrößen einer elektrischen Maschine bzw. zur Motorparameteridentifikation werden herkömmlich Stromantworten der elektrischen Maschine gemessen, die sich aufgrund von an den Motor angelegten Spannungspulsmustern ergeben. Hierdurch lassen sich beispielsweise die Induktivitäten oder die ohmschen Widerstände der elektrischen Maschine ermitteln. Während die Stromantworten vergleichsweise exakt gemessen werden können, werden die Spannungspulsmuster herkömmlich nicht gemessen, sondern in ihren Eigenschaften als bekannt vorausgesetzt bzw. geschätzt.

Die DE 10 2014 116 216 A1 zeigt ein System und ein Verfahren zur Überwachung des Leckstroms einer industriellen Maschine, bei denen Spannungssignale und Stromsignale mittels A/D-Wandlern gewandelt werden.

Die US 5,477,163 A zeigt ein Verfahren zur Detektion von Fehlern in einem Induktionsmotor, bei dem Motorsignale im Zeitmultiplex mittels eines A/D-Wandlers gewandelt werden.

Die DE 10 2011 080 586 A1 zeigt ein Verfahren zum Erzeugen eines digitalen Signals unter Verwendung eines Sigma-Delta-Modulators.

Die DE 10 2010 042 946 A1 zeigt einen Frequenzumrichter, bei dem ein analoges, zu überwachendes Betriebssignal mittels eines Sigma-Delta-Modulators gewandelt wird.

Der Erfindung liegt die Aufgabe zugrunde, ein Verfahren zum Ermitteln mindestens einer Kenngröße einer elektrischen Maschine und einen Frequenzumrichter zur Verfügung zu stellen, die ein einfaches und zuverlässiges Ermitteln der Kenngröße ermöglichen.

Der Erfindung löst diese Aufgabe durch ein Verfahren zum Ermitteln mindestens einer Kenngröße einer elektrischen Maschine nach Anspruch 1 und einen Frequenzumrichter nach Anspruch 3.

Das erfindungsgemäße Verfahren dient zum Ermitteln einer oder mehrerer Kenngrößen einer elektrischen Maschine, beispielsweise in Form eines Elektromotors. Die elektrische Maschine weist herkömmlich mehrere Motorphasen auf, beispielsweise drei Motorphasen. Die elektrische Maschine kann beispielsweise eine Synchronmaschine, eine Reluktanzmaschine oder eine Induktionsmaschine sein.

Es wird mindestens eine zeitlich veränderliche Spannung, insbesondere eine sinusförmige Spannung, zwischen den Motorphasen (beispielsweise zwischen zwei Motorphasen) der elektrischen Maschine erzeugt.

Die mindestens eine zeitlich veränderliche Spannung wird analog-digital-gewandelt.

Mindestens ein Strom in den bzw. in die Motorphasen (beispielsweise in eine der Motorphasen), der sich in Abhängigkeit von den zeitlich veränderlichen Spannungen einstellt, wird analog-digital-gewandelt.

Die mindestens eine Kenngröße wird in Abhängigkeit von der mindestens einen analog-digital-gewandelten Spannung und dem mindestens einen analog-digital-gewandelten Strom bestimmt, beispielsweise indem die gewandelten Größen durcheinander dividiert werden. Insoweit sei auch auf die einschlägige Fachliteratur verwiesen.

Das analog-digital-Wandeln der mindestens einen Spannung und das analog-digital-Wandeln des mindestens einen Stroms werden mit jeweils identischen analog-digital-Wandlungseigenschaften durchgeführt. Hierzu werden identische analog-digital-Wandler und identische Filter verwendet, wobei das Abtasten der Spannung und des Strom zu identischen Abtastzeitpunkten erfolgt, so dass ein phasenrichtiger Bezug zwischen Spannung und Strom gegeben ist.

Aus der bzw. den Spannungen und dem bzw. den Strömen werden jeweils zugehörige Bitströme mittels eines zugeordneten Sigma-Delta-Modulators erzeugt, wobei die Sigma-Delta-Modulatoren identisch aufgebaut und identisch parametriert sind, so dass die Sigma-Delta-Modulatoren bei identischen Eingangsgrößen identische Bitströme erzeugen würden.

Die Bitströme werden jeweils mittels digitaler Filter höherer Ordnung, beispielsweise 2. oder 3. Ordnung, zum Erzeugen von zeitlich aufeinanderfolgenden digitalen Abtastwerten gefiltert, wobei die digitalen Filter identische Filtereigenschaften aufweisen.

Ein jeweiliges digitales Filter kann beispielsweise eine sinc³-Filterfunktion aufweisen.

Die mindestens eine Kenngröße wird aus folgender Menge von Kenngrößen ausgewählt: differentielle Längsinduktivitäten, differentielle Querinduktivitäten, Kreuzsättigung, Widerstände und Impedanzen.

Der erfindungsgemäße Frequenzumrichter ist zum Durchführen des oben genannten Verfahrens ausgebildet.

Der Frequenzumrichter weist eine Wechselrichtereinheit auf, die dazu ausgebildet ist, die mindestens eine zeitlich veränderliche Spannung zwischen den Motorphasen der elektrischen Maschine zu erzeugen.

Der Frequenzumrichter weist weiter eine Anzahl, beispielsweise zwei oder drei, von ersten analog-digital-Wandlern zum analog-digital-Wandeln der zeitlich veränderlichen Spannungen auf.

Der Frequenzumrichter weist weiter eine Anzahl, beispielsweise zwei oder drei, von zweiten analog-digital-Wandlern zum analog-digital-Wandeln der Ströme in den Motorphasen auf.

Die ersten und die zweiten analog-digital-Wandler sind identisch ausgebildet, d.h. weisen eine identische Struktur und Parametrierung auf.

Der Frequenzumrichter weist weiter eine Prozessoreinheit auf, beispielsweise in Form eines Mikroprozessors. Die Prozessoreinheit ist zum Bestimmen der mindestens einen Kenngröße in Abhängigkeit von den analog-digital-gewandelten Spannungen und den analog-digital-gewandelten Strömen ausgebildet.

Der Erfindung liegt zugrunde, dass Phasenspannungen und Motorströme identisch gemessen werden. Die derart ermittelten Strom- und Spannungswerte sind somit phasenrichtig und nicht mit Wechselrichterfehlern behaftet. Erfindungsgemäß werden gleichartige Pfade für Strom- und Spannungsmessung unter Verwendung von Filtern höherer Ordnung verwendet, um eine phasenrichtige Messung komplexer Impedanzen zur Ermittlung von Motorparametern zu ermöglichen.

Alle Signale, beispielsweise Spannungen und Ströme, die zum Ermitteln der mindestens einen Kenngröße der elektrischen Maschine relevant sind, werden identisch erfasst und gefiltert. Dies bewirkt, dass sich Verfälschungen innerhalb der einzelnen Signale, die sich möglicherweise systematisch aufgrund des Erfassens und Filterns ergeben, bei der Ermittlung der Kenngröße in idealer Weise kompensieren, ohne dass die konkreten Verfälschungen bekannt seien müssen. Dies kann beispielsweise bedeuten, dass auch solche Signale, die keine dominanten Frequenzen oder Rauschen aufweisen und somit kein spezifisches Filtern benötigen, dieselben Filter durchlaufen wie Signale, die dominante Frequenzen oder Rauschen aufweisen und somit ein spezifisches Filtern benötigen. Darüber hinaus kann für Zwecke, in welchen diese Signale in unverfälschter Weise benötigt werden, eine Erfassung auch über parallel angeordnete andersartige Filter erfolgen.

Für die Signalaufbereitung verrauschter Signale werden erfindungsgemäß insbesondere Filter höherer Ordnung eingesetzt, wobei sinc Filter höherer Ordnung und Fensterfilter (z.B. Hanning-Fenster) sowie Notch kombiniert werden können.

Das Erzeugen der zeitlich veränderlichen Spannungen zwischen den Motorphasen der elektrischen Maschine kann mittels Aufmodulieren von Trägerfrequenzen, Gleichanteilen, oder aber auch während des normalen Betriebs durch Ausnutzung anwendungsbedingt bereits vorhandener Frequenzanteile erfolgen, da diese Frequenzanteile phasenrichtig zueinander in Bezug genommen werden können.

Das analog-digital-Wandeln der Spannungen und Ströme kann beispielsweise wie in der EP 2 557 426 A2 und/oder in der WO 2014/114755 A2 beschrieben erfolgen. Das Erzeugen der zeitlich veränderlichen Spannungen in Verbindung mit dem analog-digital-Wandeln der Spannungen und Ströme kann beispielsweise wie in der EP 2 302 781 A2 beschrieben erfolgen.

Die Erfindung wird nachfolgend unter Bezugnahme auf die Zeichnungen detailliert beschrieben. Hierbei zeigen schematisch:
- Fig. 1: eine mehrphasige elektrische Maschine, die mittels eines Frequenzumrichters angesteuert ist, wobei der Frequenzumrichter Spannungen und Ströme misst, die zum Ermitteln mindestens einer Kenngröße der elektrischen Maschine dienen, und
- Fig. 2: einen analog-digital-Wandler mit einem Sigma-Delta-Modulator und einem nachgeschaltetem Filter zum analog-digital-Wandeln von Strömen und Spannungen der in Fig. 1 gezeigten elektrischen Maschine.

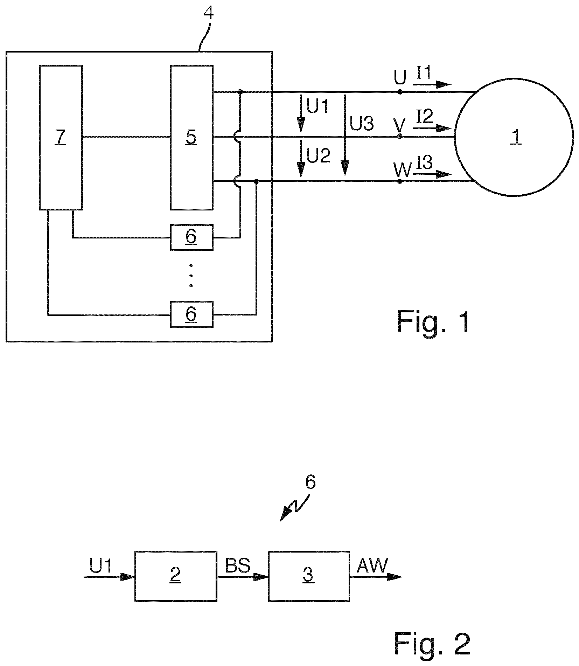

Fig. 1 zeigt eine dreiphasige elektrische Maschine 1, die mittels eines Frequenzumrichters 4 angesteuert wird, wobei der Frequenzumrichter 4 zeitlich veränderliche Spannungen U1, U2, U3 und Ströme l1, l2, l3 misst, die zum Ermitteln mindestens einer Kenngröße, beispielsweise einer oder mehrerer Impedanzen, der elektrischen Maschine 1 dienen. Als weitere Kenngrößen können beispielsweise differentielle Längsinduktivitäten, differentielle Querinduktivitäten, Kreuzsättigung und Widerstände ermittelt werden.

Die elektrische Maschine weist herkömmlich drei Motorphasen U, V, W auf. Der Frequenzumrichter 4 weist herkömmlich eine Wechselrichtereinheit 5 auf, die dazu ausgebildet ist, die zeitlich veränderlichen Spannungen U1, U2, U3 zwischen den Motorphasen U, V, W der elektrischen Maschine 1 zu erzeugen.

Der Frequenzumrichter 4 weist eine Anzahl, beispielsweise 6, von analog-digital-Wandlern 6 zum analog-digital-Wandeln der Spannungen U1, U2, U3 und der Ströme l1, l2, l3 auf. Da eine der Spannungen bzw. einer der Ströme sich rechnerisch aus den anderen beiden Spannungen bzw. Strömen ermitteln lässt, kann die Anzahl der analog-digital-Wandler 6 gegebenenfalls auf vier reduziert werden. Jeder zu messenden Spannung und jedem zu messenden Strom ist genau einer der analog-digital-Wandler 6 zugeordnet. Die analog-digital-Wandler 6 sind identisch aufgebaut.

Den analog-digital-Wandlern 6 können identisch aufgebaute analoge Filter vorgeschaltet sein.

Der Frequenzumrichter 1 weist weiter eine Prozessoreinheit 7 auf, die in Abhängigkeit von den analog-digital-gewandelten Spannungen und den analog-digital-gewandelten Strömen die Impedanz(en) bestimmt.

Fig. 2 zeigt exemplarisch einen der analog-digital-Wandler 6 in seinem inneren Aufbau. Die verbleibenden analog-digital-Wandler 6 sind identisch. Der gezeigte analog-digital-Wandler 6 dient zum analog-digital-Wandeln der Spannung U1.

Der analog-digital-Wandler 6 weist einen Sigma-Delta-Modulator 2 und ein nachgeschaltetes digitales Filter mit sinc³-Filterfunktion auf. Weiter wird herkömmlich eine nicht näher dargestellte Abtastratenkonvertierung durchgeführt. Insoweit sei auch auf die einschlägige Fachliteratur verwiesen.

Die Spannungen U1, U2, U3 werden in der gezeigten Ausführungsform zwischen den Motorphasen U, V, W gemessen. Es versteht sich, dass die Spannungen auch als Stern messbar sein können.

Mittels der gezeigten Ausführungsform werden die Phasenspannungen U1, U2, U3 und die Motorströme I1, I2 und I3 identisch gemessen bzw. analog-digital-gewandelt. Die derart ermittelten Strom- und Spannungswerte sind somit phasenrichtig und nicht mit Wechselrichterfehlern behaftet. Erfindungsgemäß werden gleichartige Pfade für Strom- und Spannungsmessung unter Verwendung von Filtern höherer Ordnung verwendet.

## Patentansprüche

1. Verfahren zum Ermitteln mindestens einer Kenngröße einer elektrischen Maschine (1), wobei die elektrische Maschine mehrere Motorphasen (U, V, W) aufweist, mit den Schritten:
- Erzeugen von zeitlich veränderlichen Spannungen (U1, U2, U3) zwischen den Motorphasen (U, V, W) der elektrischen Maschine (1),
- analog-digital-Wandeln der zeitlich veränderlichen Spannungen(U1, U2, U3),
- analog-digital-Wandeln von Strömen (I1, I2, I3) in den Motorphasen (U, V, W), die sich in Abhängigkeit von den zeitlich veränderlichen Spannungen (U1, U2, U3) einstellen, und
- Bestimmen der Kenngröße in Abhängigkeit von den analog-digital-gewandelten Spannungen und den analog-digital-gewandelten Strömen,
**dadurch gekennzeichnet, dass**
- ein Abtasten einer jeweiligen Spannung und eines zugehörigen Stroms zu identischen Abtastzeitpunkten erfolgt, und
- aus den Spannungen und den Strömen jeweils zugehörige Bitströme (BS) mittels eines jeweiligen Sigma-Delta-Modulators (2) erzeugt werden, wobei die Sigma-Delta-Modulatoren (2) identisch aufgebaut sind,
- wobei die Bitströme (BS) jeweils mittels digitaler Filter (3) höherer Ordnung zum Erzeugen von zeitlich aufeinanderfolgenden digitalen Abtastwerten (AW) gefiltert werden, wobei die digitalen Filter identische Filtereigenschaften aufweisen, und
- wobei die mindestens eine Kenngröße ausgewählt ist aus der Menge von Kenngrößen:
- differentielle Längsinduktivitäten,
- differentielle Querinduktivitäten,
- Kreuzsättigung,
- Widerstände und
- Impedanzen.

2. Verfahren nach Anspruch 1, **dadurch gekennzeichnet, dass**
- dass ein jeweiliges digitales Filter (3) eine sinc³-Filterfunktion aufweist.

3. Frequenzumrichter (4), der zum Durchführen eines Verfahrens nach einem der vorhergehenden Ansprüche ausgebildet ist, aufweisend:
- eine Wechselrichtereinheit (5), die dazu ausgebildet ist, die zeitlich veränderlichen Spannungen (U1, U2, U3) zwischen den Motorphasen (U, V, W) der elektrischen Maschine (1) zu erzeugen,
- eine Anzahl von ersten analog-digital-Wandlern (6) zum analog-digital-Wandeln der zeitlich veränderlichen Spannungen,
- eine Anzahl von zweiten analog-digital-Wandlern (6) zum analog-digital-Wandeln der Ströme in den Motorphasen (U, V, W),
- wobei die ersten und die zweiten analog-digital-Wandler (6) jeweils einen Sigma-Delta-Modulator (2) und ein nachgeschaltetes digitales Filter (3) aufweisen, wobei die Sigma-Delta-Modulatoren (2) der ersten und der zweiten analog-digital-Wandler (6) identisch aufgebaut sind und die digitalen Filter (3) der ersten und der zweiten analog-digital-Wandler (6) identische Filtereigenschaften aufweisen, und
- eine Prozessoreinheit (7) zum Bestimmen der mindestens einen Kenngröße in Abhängigkeit von den analog-digital-gewandelten Spannungen und den analog-digital-gewandelten Strömen.

## Claims

1. Method for determining at least one parameter of an electric machine (1), wherein the electric machine has multiple motor phases (U, V, W), comprising the steps:
- generating time variable voltages (U1, U2, U3) between the motor phases (U, V, W) of the electric machine (1),
- analogue-digital converting of the time variable voltages (U1, U2, U3),
- analogue-digital converting of currents (I1, I2, I3) in the motor phases (U, V, W) occurring as a function of the time variable voltages (U1, U2, U3), and
- determining of the parameter as a function of the analogue-digital converted voltages and the analogue-digital converted currents,
**characterized in that**
- sampling of a respective voltage and of a corresponding current is done at identical sampling time, and
- from the voltages and the currents, corresponding bitstreams (BS) are generated using a respective sigma-delta modulator (2), wherein the sigma-delta modulators (2) have an identical design,
- wherein the bitstreams (BS) each are filtered using digital filters (3) of higher order for generating digital sample values (AW) which are successive in time, wherein the digital filters have identical filter characteristics, and
- wherein the at least one parameter is selected from the set of parameters:
- differential longitudinal inductances,
- differential transverse inductances,
- cross saturation,
- resistances, and
- impedances.

2. Method according to claim 1, **characterized in that**
- a respective digital filter (3) has a sinc³ filter function.

3. Frequency converter (4), configured for carrying out a method according to any of the preceding claims, comprising:
- an inverter device (5), configured for generating the time variable voltages (U1, U2, U3) between the motor phases (U, V, W) of the electric machine (1),
- a number of first analogue-digital converters (5) for analogue-digital converting of the time variable voltages,
- a number of second analogue-digital converters (6) for analogue-digital converting of the currents in the motor phases (U, V, W),
- wherein the first and the second analogue-digital converters (6) each include a sigma-delta modulator (2) and a downstream digital filter (3), wherein the sigma-delta modulators (2) of the first and the second analogue-digital converters (6) have an identical design, and the digital filters (3) of the first and the second analogue-digital converters (6) have identical filter characteristics, and
- a processor device (7) for determining the at least one parameter as a function of the analogue-digital converted voltages and the analogue-digital converted currents.

## Revendications

1. Procédé de détermination d'au moins une grandeur caractéristique d'une machine électrique (1), la machine électrique présentant plusieurs phases de moteur (U, V, W), comprenant les étapes consistant à :
- générer des tensions (U1, U2, U3) variables dans le temps entre les phases de moteur (U, V, W) de la machine électrique (1),
- convertir d'analogique en numérique les tensions (U1, U2, U3) variables dans le temps,
- convertir d'analogique en numérique des courants (I1, I2, I3) dans les phases de moteur (U, V, W) qui apparaissent en fonction des tensions (U1, U2, U3) variables dans le temps, et
- déterminer la grandeur caractéristique en fonction des tensions converties d'analogique en numérique et des courants convertis d'analogique en numérique,
**caractérisé en ce que**
- un balayage de chaque tension et d'un courant associé est effectué à des instants de balayage identiques, et
- à partir des tensions et des courants, des trains binaires (BS) respectivement associés sont générés au moyen d'un modulateur sigma-delta (2) respectif, les modulateurs sigma-delta (2) étant de construction identique,
- dans lequel les trains binaires (BS) sont filtrés respectivement au moyen de filtres numériques (3) d'ordre supérieur pour générer des valeurs de balayage numériques (AW) successives dans le temps, les filtres numériques présentant des propriétés de filtrage identiques, et
- dans lequel ladite au moins une grandeur caractéristique est sélectionnée dans l'ensemble de grandeurs caractéristiques :
- des inductances longitudinales différentielles,
- des inductances transversales différentielles,
- de la saturation croisée,
- des résistances, et
- des impédances.

2. Procédé selon la revendication 1, **caractérisé en ce que**
- un filtre numérique (3) respectif présente une fonction de filtrage sinc³.

3. Convertisseur de fréquence (4), réalisé pour effectuer un procédé selon l'une quelconque des revendications précédentes, présentant :
- une unité inverseuse (5) qui est réalisée pour générer les tensions (U1, U2, U3) variables dans le temps entre les phases de moteur (U, V, W) de la machine électrique (1),
- un nombre de premiers convertisseurs analogique/numérique (6) pour convertir d'analogique en numérique les tensions variables dans le temps,
- un nombre de deuxièmes convertisseurs analogique/numérique (6) pour convertir d'analogique en numérique les courants dans les phases de moteur (U, V, W),
dans lequel les premiers et les deuxièmes convertisseurs analogique/numérique (6) présentent respectivement un modulateur sigma-delta (2) et un filtre numérique (3) placé en aval, les modulateurs sigma-delta (2) des premiers et des deuxièmes convertisseurs analogique/numérique (6) étant de construction identique, et les filtres numériques (3) des premiers et des deuxièmes convertisseurs analogique/numérique (6) présentant des propriétés de filtrage identiques, et
- une unité de processeur (7) pour déterminer ladite au moins une grandeur caractéristique en fonction des tensions converties d'analogique en numérique et des courants convertis d'analogique en numérique.
